# EUROPEAN PATENT APPLICATION

(11) **EP 2 808 899 A1**
(43) Date of publication of application: **03.12.2014**
(21) Application number: 12866421.6
(22) Date of filing: 26.01.2012
(51) Int. Cl.: H01L 29/861, H01L 21/8234, H01L 27/04, H01L 27/06, H01L 27/088, H01L 29/739, H01L 29/78

(54) **SEMICONDUCTOR DEVICE AND POWER CONVERSION APPARATUS USING SAME**

(71) Applicant: Hitachi, Ltd., Tokyo 100-8280 (JP)
(72) Inventor: HASHIMOTO Takayuki, Chiyoda-ku Tokyo 100-8280 (JP); MASUNAGA Masahiro, Chiyoda-ku Tokyo 100-8280 (JP)
(74) Representative: MERH-IP Matias Erny Reichl Hoffmann
(86) International application number: PCT/JP2012/051606
(87) International publication number: WO 2013/111294

(57) **Abstract**

A semiconductor device (10) includes an n-type drift layer (11) that is a semiconductor substrate; a p-type region (12) and an n-type region (13) that are formed on a surface of the semiconductor substrate and serving as anode regions; a high-concentration n-type region (15) formed on a back surface of the semiconductor substrate and serving as a cathode region; and an anode electrode (1). The semiconductor substrate includes, on its surface, a structure in which the p-type region (12) and the n-type region (13) are adjacent to each other, wherein the p-type region (12) is connected to the anode electrode (1), and the n-type region (13) is connected to the anode electrode (1) via a switch (14). A control unit (40) is connected to a control terminal of the switch (14). In a conduction state of the semiconductor device (10), the control unit (40) outputs a high-frequency pulse to the control terminal of the switch (14) to turn on and off the switch (14).

## Description

### Technical Field

The present invention relates to a semiconductor device, and a power conversion device using the same. The present invention particularly relates to a power conversion device used for a low electric power device such as an air conditioner or a microwave oven and a high electric power device such as an inverter for a railroad or a steel plant, and a semiconductor device used for the power conversion device.

### Background Art

Recently, power-saving power conversion devices and power conversion devices using new energy employ many inverters and converters. However, such power conversion devices have to be markedly in widespread use for realizing a low-carbon society.

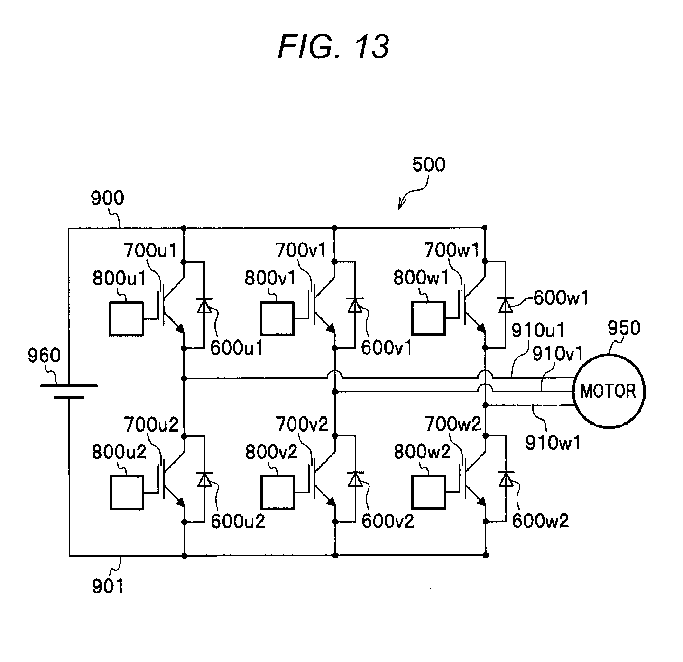

FIG. 13 is a circuit diagram illustrating a power conversion device (inverter).

An inverter 500 variably controls a rotation speed of a motor 950 to realize energy saving.

In order to variably control the rotation speed of the motor 950, the inverter 500 converts electric energy supplied from a power source 960 into AC with a desired frequency by using IGBTs (Insulated Gate Bipolar Transistors) 700u1 to 700w2 that are one of power semiconductors. The inverter 500 includes a U-phase switching leg, a V-phase switching leg, and a W-phase switching leg, which are connected between a positive power source terminal 900 and a negative power source terminal 901. The U-phase switching leg outputs a signal of a U-phase 910u to the motor 950. The V-phase switching leg outputs a signal of a V-phase 910v to the motor 950. The W-phase switching leg outputs a signal of a W-phase 910w to the motor 950.

The U-phase switching leg includes the IGBT 700u1 and a fly wheel diode 600u1, which are an upper arm, and an IGBT 700u2 and a fly wheel diode 600u2, which are a lower arm. A collector terminal of the IGBT 700u1 is connected to the positive power source terminal 900. An emitter terminal of the IGBT 700u1 is connected to a collector terminal of the IGBT 700u2. An emitter terminal of the IGBT 700u2 is connected to the negative power source terminal 901. The fly wheel diode 600u1 is connected in parallel to the IGBT 700u1 in the opposite direction. The fly wheel diode 600u2 is connected in parallel to the IGBT 700u2 in the opposite direction.

An output of a gate circuit 800u1 is connected to a gate terminal of the IGBT 700u1. An output of a gate circuit 800u2 is connected to a gate terminal of the IGBT 700u2.

The U-phase 910u is outputted from a node where the emitter terminal of the IGBT 700u1 and the collector terminal of the IGBT 700u2 are connected.

Like the U-phase switching leg, the V-phase switching leg includes an IGBT 700v1 and a fly wheel diode 600v1, which are an upper arm, and an IGBT 700v2 and a fly wheel diode 600v2, which are a lower arm.

A collector terminal of the IGBT 700v1 is connected to the positive power source terminal 900. An emitter terminal of the IGBT 700v1 is connected to a collector terminal of the IGBT 700v2. An emitter terminal of the IGBT 700v2 is connected to the negative power source terminal 901. The fly wheel diode 600v1 is connected in parallel to the IGBT 700v1 in the opposite direction. The fly wheel diode 600v2 is connected in parallel to the IGBT 700v2 in the opposite direction.

An output of a gate circuit 800v1 is connected to a gate terminal of the IGBT 700v1. An output of a gate circuit 800v2 is connected to a gate terminal of the IGBT 700v2.

The V-phase 910v is outputted from a node where the emitter terminal of the IGBT 700v1 and the collector terminal of the IGBT 700v2 are connected.

Like the U-phase switching leg, the W-phase switching leg includes the IGBT 700w1 and a fly wheel diode 600w1, which are an upper arm, and the IGBT 700w2 and a fly wheel diode 600w2, which are a lower arm.

A collector terminal of the IGBT 700w1 is connected to the positive power source terminal 900. An emitter terminal of the IGBT 700w1 is connected to a collector terminal of the IGBT 700w2. An emitter terminal of the IGBT 700w2 is connected to the negative power source terminal 901. The fly wheel diode 600w1 is connected in parallel to the IGBT 700w1 in the opposite direction. The fly wheel diode 600w2 is connected in parallel to the IGBT 700w2 in the opposite direction.

An output of a gate circuit 800w1 is connected to a gate terminal of the IGBT 700w1. An output of a gate circuit 800w2 is connected to a gate terminal of the IGBT 700w2.

The W-phase 910w is outputted from a node where the emitter terminal of the IGBT 700w1 and the collector terminal of the IGBT 700w2 are connected.

When the IGBTs 700u1, 700u2, 700v1, 700v2, 700w1, and 700w2 are not particularly distinguished, the IGBT is merely described as an IGBT 700. When the fly wheel diodes 600u1, 600u2, 600v1, 600v2, 600w1, and 600w2 are not particularly distinguished, the fly wheel diode is merely described as a fly wheel diode 600.

The motor 950 is a three-phase motor including input terminals of the U-phase 910u, V-phase 910v, and W-phase 910w.

When the gate circuit 800u1 turns off the IGBT 700u1 with the IGBT 700u2 being turned off by the gate circuit 800u2 in the U-phase switching leg, positive current flows through the U-phase 910u of the motor 950 from the IGBT 700u1, and when the gate circuit 800u1 turns off the IGBT 700u1, current does not flow through the U-phase 910u.

In the U-phase switching leg, when the gate circuit 800u1 applies a PWM (Pulse Width Modulation) signal to the gate terminal of the IGBT 700u1, positive current according to a duty ratio of the PWM signal flows through the U-phase 910u.

When the gate circuit 800u2 turns on the IGBT 700u2 with the IGBT 700u1 being turned off by the gate circuit 800u1 in the U-phase switching leg, negative current flows through the U-phase 910u of the motor 950 from the IGBT 700u2, and when the gate circuit 800u2 turns off the IGBT 700u2, current does not flow through the U-phase 910u. In the U-phase switching leg, when the gate circuit 800u2 applies a PWM signal to the gate terminal of the IGBT 700u2, negative current according to a duty ratio of the PWM signal flows through the U-phase 910u. AC with a desired frequency can be sent to the motor 950 by the repeated control described above.

In the V-phase switching leg, current can be sent to the V-phase 910v by the control similar to the control for the U-phase switching leg. In the W-phase switching leg, current can be sent to the W-phase 910w by the control similar to the control for the U-phase switching leg.

For example, when the IGBT 700u1 in the upper arm is turned off, the fly wheel diode 600u1 commutates the current flowing through the IGBT 700u1 to the fly wheel diode 600u2 connected to the IGBT 700u2 in the lower arm in parallel in the opposite direction. Thus, the fly wheel diodes 600u1 and 600u2 discharge electromagnetic energy stored in a coil (not illustrated) of the motor 950.

When the IGBT 700u1 in the upper arm is again turned on later, the fly wheel diode 600u2 in the lower arm is in non-conduction state, whereby electric power is supplied to the motor 950 via the IGBT 700u1 in the upper arm. The IGBTs 700u1 and 700u2 and the fly wheel diodes 600u1 and 600u2 generate a conduction loss in the conduction state, and generate a switching loss upon switching.

The same applies to the IGBTs 700v1 and 700v2 and the fly wheel diodes 600v1 and 600v2. The same also applies to the IGBTs 700w1 and 700w2 and the fly wheel diodes 600w1 and 600w2.

Accordingly, the reduction in the conduction loss and the switching loss of the IGBT 700 are needed, and further, the reduction in the conduction loss and the switching loss of the fly wheel diode 600 is also needed, to downsize the inverter 500 and to increase efficiency of the inverter 500.

NPLs 1 and 2 describe a method (hereinafter referred to as a pulse hole injection) of injecting holes from an anode electrode 1 in a form of a pulse for reducing the conduction loss of the fly wheel diode 600.

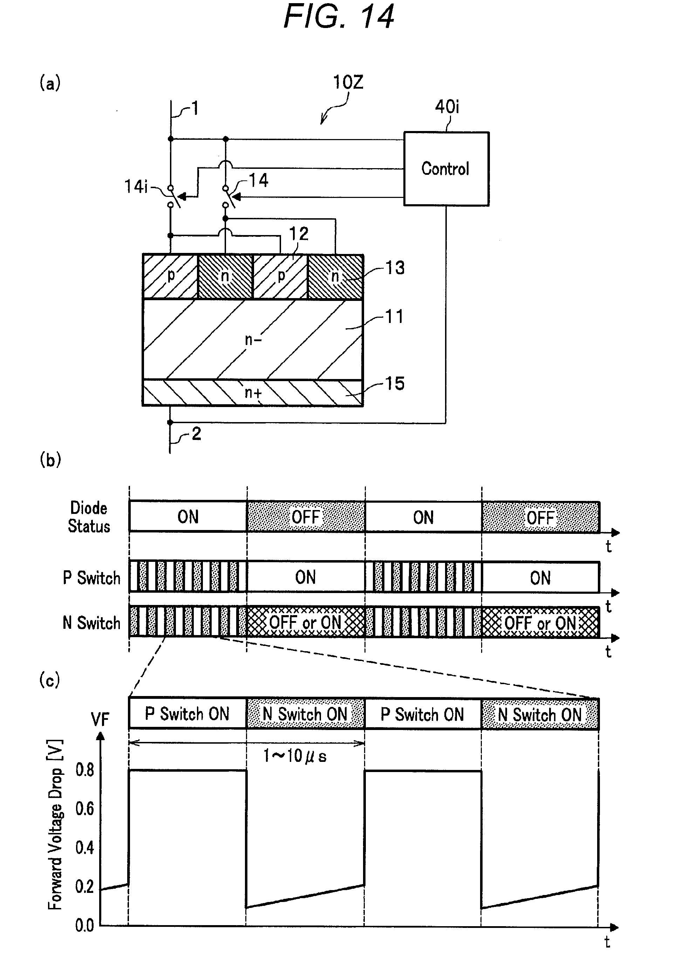

FIGS. 14(a) to 14(c) are diagrams illustrating a configuration and an operation of a diode in a comparative example. The reason why the conduction loss of a diode 10Z is reduced by the pulse hole injection will be described with reference to FIGS. 14(a) to 14(c).

FIG. 14(a) is a diagram illustrating the configuration of the diode in the comparative example.

The diode 10Z that is a semiconductor device in the comparative example includes a semiconductor substrate that is an n-type drift layer 11, a p-type region 12, an n-type region 13, switches 14 and 14i, a high-concentration n-type region 15, and a control unit 40i. An "n-" illustrated in the n-type drift layer 11 indicates that an impurity concentration in the semiconductor is low.

The diode 10Z sends forward current when voltage is applied in the direction from the anode electrode 1 to a cathode electrode 2.

The n-type drift layer 11 is a semiconductor substrate of the diode 10Z.

The p-type region 12 and the n-type region 13 that are anode regions are formed adjacent to each other on the surface (first surface) of the semiconductor substrate. The p-type region 12 is connected to the anode electrode 1 via the switch 14i. The n-type region 13 is connected to the anode electrode 1 via the switch 14.

The high-concentration n-type region 15 that is a cathode region is formed on the back surface (second surface) of the semiconductor substrate. The high-concentration n-type region 15 is connected to the cathode electrode 2.

The control unit 40i is connected to the anode electrode 1 and the cathode electrode 2. A P switch terminal of the control unit 40i is connected to a control terminal of the switch 14i, while an N switch terminal of the control unit 40i is connected to a control terminal of the switch 14. The control unit 40i detects a conduction state/non-conduction state of the diode 10Z by comparing the voltage of the anode electrode 1 and the voltage of the cathode electrode 2. The conduction state of the diode 10Z means that the voltage of the anode electrode 1 is higher than the voltage of the cathode electrode 2. The non-conduction state of the diode 10Z means that the voltage of the anode electrode 1 is not more than the voltage of the cathode electrode 2.

After detecting the conduction state of the diode 10Z, the control unit 40i outputs a complementary high-frequency pulse to the P switch terminal and the N switch terminal to complementarily repeat on and off of the switches 14 and 14i. After detecting the non-conduction state of the diode 10Z, the control unit 40i outputs a signal for turning on the switch 14 to the P switch terminal. In this case, it does not matter whether the output of the N switch terminal is on or off.

FIG. 14(b) is a diagram illustrating a timing of the conduction state (on) and the non-conduction state (off) of the diode 10Z and its operation.

A "Diode Status" at an upper chart indicates the conduction state and the non-conduction state of the diode 10Z. In the "Diode Status", "ON" in a white part indicates the conduction state of the diode 10Z, while "OFF" in a gray part indicates the non-conduction state of the diode 10Z.

A "P Switch" in a central chart illustrates an on-state and an off-state of the switch 14i. In the "P Switch", "ON" in a white part indicates the on-state of the switch 14i, while a gray part indicates the off-state of the switch 14i. The "P Switch" simultaneously indicates a signal of the P switch terminal outputted by the control unit 40i to the switch 14i.

An "N Switch" in a lower chart illustrates an on-state and an off-state of the switch 14. In the "N Switch", a white part indicates the on-state of the switch 14, a gray part indicates the off-state of the switch 14, and "OFF or ON" in an oblique check pattern indicates that it does not matter whether the switch 14 is on or off. The "N Switch" simultaneously indicates a signal of the N switch terminal outputted by the control unit 40i to the switch 14. A horizontal axis indicates a time t common to the "Diode Status", the "P Switch", and the "N Switch".

In the conduction state of the diode 10Z, the control unit 40i outputs a high-frequency pulse to the P switch terminal, and outputs a complementary pulse, which is formed by inverting the pulse, to the N switch terminal, thereby complementarily repeating the on and off of the switches 14 and 14i. In the conduction state of the diode 10Z, the switches 14 and 14i complementarily repeats the on and off.

In the non-conduction state, the control unit 40i outputs the signal of turning on the switch 14i to the P switch terminal. In the non-conduction state of the diode 10Z, the switch 14i is turned on. In this case, it does not matter whether the signal outputted to the N switch terminal is on or off.

FIG. 14(c) is a diagram illustrating a relationship between the timing when the two switches 14 and 14i at the side of the anode electrode 1 are complementarily turned on and off and a forward voltage drop VF between the anode electrode 1 and the cathode electrode 2 in the conduction state of the diode 10Z.

A "P switch ON" indicates that the switch 14i for the p-type region 12 is on, and the switch 14 for the n-type region 13 is off. In the "P Switch ON", holes are injected into the n-type drift layer 11 (semiconductor substrate) from the P-type region 12. In this case, the forward voltage drop VF of the diode 10Z becomes about 0.8 V that is a diffusion voltage of a pn junction.

An "N Switch ON" indicates that the switch 14i for the n-type region 13 is on, and the switch 14 for the p-type region 12 is off. When the device is changed to the "N Switch ON" from the "P Switch ON", the n-type drift layer 11 (semiconductor substrate) keeps a low resistance due to the remaining holes. In this case, the forward voltage drop VF of the diode 10Z is reduced to about 0.2 V, since the pn junction is not present on a path of anode current. The period from when the device is changed to the "P Switch ON" and then, switched to the "N Switch ON" till when the device is again changed to the "P Switch ON" is 1 to 10 microseconds. Specifically, the switches 14 and 14i are turned on and off with a pulse having a frequency of 1 GHz to 100 MHz.

In the diode 10Z in the comparative example, the hourly-averaged forward voltage drop VF becomes 0.4 V, which is significantly lower than 0.8 V that is the forward voltage drop of a conventional pin (p-intrinsic-n) diode.

In the "N Switch ON" in FIG. 14(c), the forward voltage drop VF gradually increases. This is because the holes injected into the n-type drift layer 11 (semiconductor substrate) during the period when the switch 14i for the p-type region 12 is turned on move to the cathode electrode 2 via the high-concentration n-type region 15. When the holes in the n-type drift layer 11 (semiconductor substrate) decreases, the resistance of the n-type drift layer 11 increases.

When the on-period, which is the "N Switch ON", of the switch 14 for the n-type region 13 is long, the resistance of the n-type drift layer 11 gradually increases, resulting in that the forward voltage drop VF of the diode 10Z might exceed the diffusion voltage of the pn junction. Accordingly, the control unit 40i has to output two complementary high-frequency pulses to each of the switch 14 for the n-type region 13 and the switch 14i for the p-type region 12 to complementarily turn on and off the switches 14 and 14i (to make a switching operation).

NPLs 1 and 2 describe that the frequency of the pulse of turning on and off the switches 14 and 14i of the diode 10Z is about 1 MHz.

### Citation List

### Non-Patent Literature

NPL 1: Y. Matsumoto et al., "Challenge to the Barrier of Conduction Loss in PiN Diode toward VF<300 mV with pulsed Carrier + Injection Concept", Proc. IEEE ISPSD' 10, June 2010., pp. 119-122
NPL 2: Y. Matsumoto et al., "Ultra Low Loss Trench Gate PCI-PiN Diode with VF<350 mV", Proc. IEEE ISPSD' 11, May 2011., pp. 84-87

### Summary of Invention

### Technical Problem

The techniques in NPLs 1 and 2 need two switches that are the switch 14 for the n-type region 13 and the switch 14i for the p-type region 12. The mounting area and cost of the semiconductor device and the power conversion device using the semiconductor device increase due to the addition of these switches 14 and 14i. The techniques in NPLs 1 and 2 need to control two switches, which might make the control circuit complicated.

In view of the above circumstances, the present invention aims to suppress a conduction loss and a recovery loss of a semiconductor device.

### Solution to Problem

A semiconductor device according to the present invention is configured as described below for solving the aforementioned problems.

The semiconductor device according to claim 1 of the present invention includes: a semiconductor substrate of a first conductive type; an anode region formed on a first surface of the semiconductor substrate; a cathode region of a first conductive type formed on a second surface of the semiconductor substrate; and an anode electrode, wherein the first surface includes a structure in which a first conductive type anode region and a second conductive type anode region are adjacent to each other, the second conductive type anode region is connected to the anode electrode, and the first conductive type anode region is connected to the anode electrode via a switch.

Other means will be described in the description of embodiments.

### Advantageous Effects of Invention

According to the invention, a conduction loss and a recovery loss of a semiconductor device can be suppressed.

### Brief Description of Drawings

[FIG. 1] FIG. 1 is a diagram illustrating a cross-sectional configuration of a diode according to a first embodiment.
[FIG. 2] FIGS. 2 (a) and 2(b) are diagrams illustrating an operation (1) of the diode according to the first embodiment.
[FIG. 3] FIGS. 3(a) and 3(b) are diagrams illustrating an operation (2) of the diode according to the first embodiment.
[FIG. 4] FIG. 4 is a diagram illustrating a cross-sectional configuration of a diode according to a second embodiment.
[FIG. 5] FIGS. 5(a) and 5(b) are diagrams illustrating a configuration and an operation of a diode according to a third embodiment.
[FIG. 6] FIG. 6 is a diagram illustrating a cross-sectional configuration of a diode according to a fourth embodiment.
[FIG. 7] FIGS. 7(a) and 7(b) are diagrams illustrating cross-sectional configurations of diodes according to fifth and sixth embodiments.
[FIG. 8] FIG. 8 is a sectional view illustrating a diode according to a seventh embodiment.
[FIG. 9] FIGS. 9 (a) and 9(b) are diagrams illustrating a configuration and an operation of a switching device according to an eighth embodiment.
[FIG. 10] FIG. 10 is a diagram illustrating a relationship between an on-voltage and a turn-off loss of the switching device.
[FIG. 11] FIGS. 11(a) and 11(b) are diagrams illustrating cross-sectional configurations of switching devices according to ninth and tenth embodiments.
[FIG. 12] FIG. 12 is a sectional view illustrating a switching device according to an eleventh embodiment.
[FIG. 13] FIG. 13 is a circuit diagram illustrating a power conversion device (inverter).
[FIG. 14] FIGS. 14(a) and 14(b) are diagrams illustrating a configuration and an operation of a diode according to a comparative example.

### Description of Embodiments

Embodiments for embodying the present invention will be described in detail with reference to respective drawings.

### (Configuration of first embodiment)

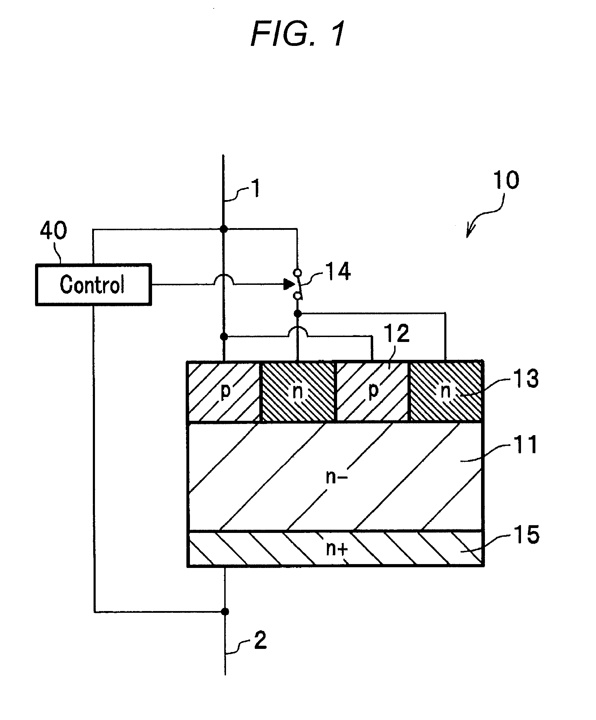

FIG. 1 is a diagram illustrating a cross-sectional configuration of a diode according to the first embodiment.

A diode 10 that is a semiconductor device according to the present embodiment includes a semiconductor substrate serving as an n-type drift layer 11, a p-type region 12, an n-type region 13, a switch 14, a high-concentration n-type region 15, and a control unit 40. An "n-" illustrated in the n-type drift layer 11 indicates that an impurity concentration in the semiconductor is low.

The diode 10 sends forward current when voltage is applied in the direction from the anode electrode 1 to the cathode electrode 2.

The n-type drift layer 11 is a semiconductor substrate of the diode 10.

The p-type region 12 and the n-type region 13 are formed adjacent to each other on the surface (first surface) of the semiconductor substrate. The region where the p-type region 12 and the n-type region 13 are adjacent to each other is an "anode region". The p-type region 12 is connected to the anode electrode 1. The n-type region 13 is connected to the anode electrode 1 via the switch 14.

The high-concentration n-type region 15 is formed on the back surface (second surface) of the semiconductor substrate. The high-concentration n-type region 15 is connected to the cathode electrode 2. In the present embodiment, a first conductive type is defined as an n-type, and a second conductive type is defined as a p-type.

The control unit 40 is connected to the anode electrode 1 and the cathode electrode 2. An output terminal of the control unit 40 is connected to a control terminal of the switch 14. The control unit 40 detects a conduction state/non-conduction state of the diode 10 by comparing the voltage of the anode electrode 1 and the voltage of the cathode electrode 2. The conduction state of the diode 10 means that the voltage of the anode electrode 1 is higher than the voltage of the cathode electrode 2. The non-conduction state of the diode 10 means that the voltage of the anode electrode 1 is not more than the voltage of the cathode electrode 2.

After detecting the conduction state of the diode 10, the control unit 40 outputs a high-frequency pulse to the control terminal of the switch 14 to repeatedly turn on and off the switch 14. After detecting the non-conduction state of the diode 10, the control unit 40 outputs a signal for turning on the switch 14 to the control terminal of the switch 14.

Specifically, the control unit 40 controls to repeatedly turn on and off the switch 14 during the period when forward voltage is applied to the diode 10. The control unit 40 also controls to turn on the switch 14 during the period when the reverse voltage is applied to the diode 10.

Different from the diode 10Z described in the NPLs 1 and 2 described above, the p-type region 12 is connected to the anode electrode 1 without using the switch 14i in the diode 10 according to the present embodiment. The diode 10 repeatedly turns on and off the switch 14 during the conduction state, thereby being capable of reducing the forward voltage drop VF as in the NPLs 1 and 2 described above.

In addition, the diode 10 according to the present embodiment uses only one switch 14. Therefore, the diode 10 according to the present embodiment can reduce the mounting area and cost more than the technique using two switches 14 and 14i described in NPLs 1 and 2.

### (Operation of first embodiment)

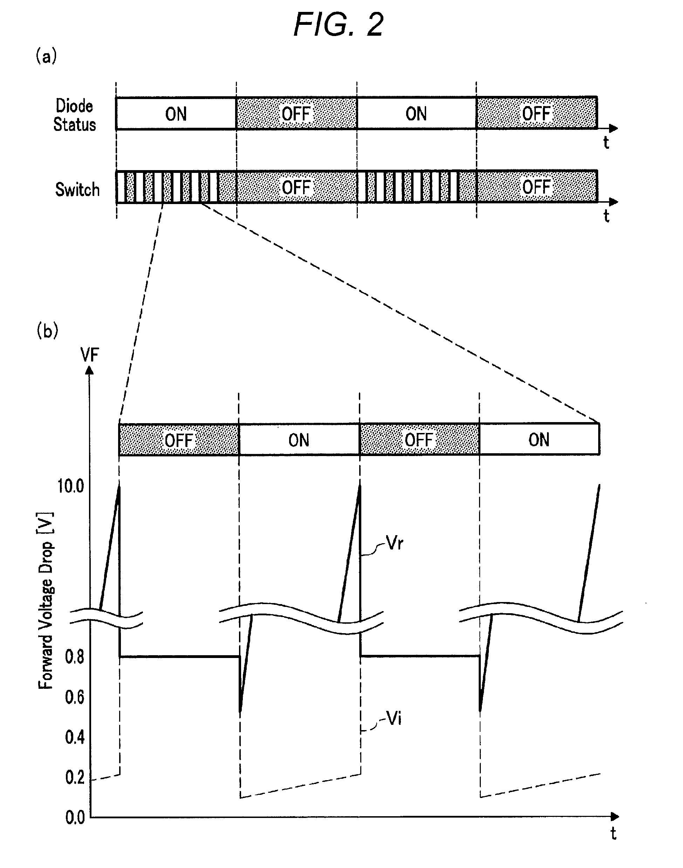

FIGS. 2(a) and 2(b) are diagrams illustrating an operation (1) of the diode according to the first embodiment. The operation of the diode 10 will be described below with reference to FIG. 1, according to need.

FIG. 2(a) illustrates the conduction/non-conduction state of the diode 10 and on/off state of the switch 14. A horizontal axis indicates a common time t.

A "Diode Status" at an upper chart indicates the conduction state and the non-conduction state of the diode 10. In the "Diode Status", "ON" in a white part indicates the conduction state of the diode 10, while "OFF" in a gray part indicates the non-conduction state of the diode 10.

A "Switch" in a lower chart illustrates an on-state and an off-state of the switch 14. In the "Switch", "ON" in a white part indicates the on-state of the switch 14, while "OFF" in a gray part indicates the off-state of the switch 14.

In the conduction state of the diode 10, the switch 14 is repeatedly turned on and off with a high-frequency pulse. The diode 10 turns off the switch 14 just before the diode 10 is changed to the non-conduction state. In the non-conduction state of the diode 10, the switch 14 is in the off-state.

FIG. 2(b) illustrates the on-state/off-state of the switch 14 at the side of the anode electrode 1 and a waveform of the forward voltage drop VF between the anode electrode 1 and the cathode electrode 2. A vertical axis in FIG. 2(b) indicates a voltage value of the forward voltage drop VF. A horizontal axis in FIG. 2(b) illustrates a time.

It is ideal that the forward voltage drop VF decreases just before the switch 14 at the side of the anode electrode 1 is turned on, and then, the forward voltage drop VF gradually increases, as indicated by a dotted line Vi. However, according to the experiment conducted by the inventors of the subject application, the forward voltage drop VF temporarily decreases, and then, sharply increases just after the switch 14 at the side of the anode electrode 1 is turned on as indicated by a solid line Vr, in the diode 10 according to the first embodiment.

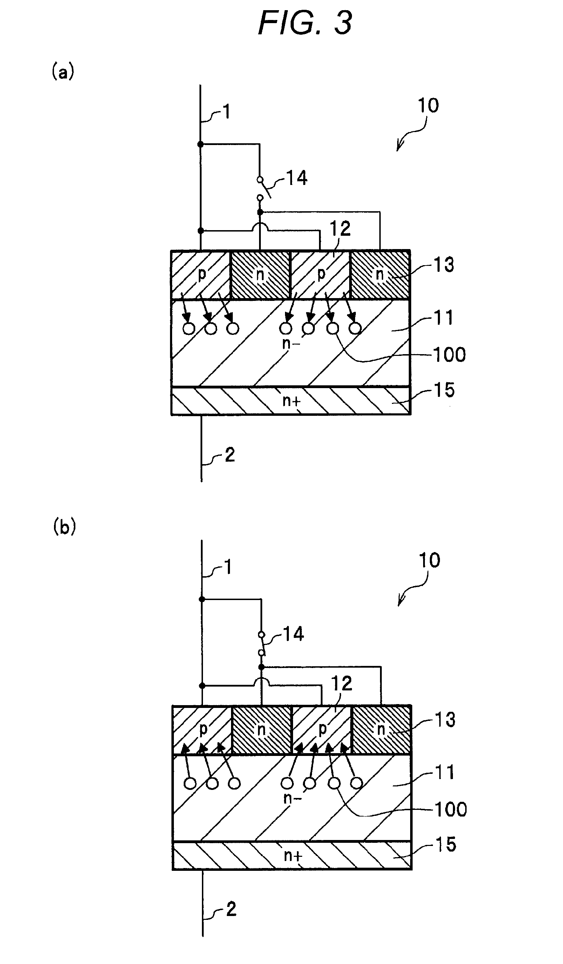

FIGS. 3(a) and 3(b) are diagrams illustrating an operation (2) of the diode according to the first embodiment.

FIG. 3(a) illustrates an internal state of the diode 10 when the switch 14 is turned off.

In this case, holes 100 are injected from the p-type region 12 into the n-type drift layer 11 (semiconductor substrate). The conductivity of the n-type drift layer 11 is modulated due to the injection of the holes 100, whereby the resistance value is decreased.

FIG. 3(b) illustrates the internal state of the diode 10 just after the switch 14 is turned on.

The moment the switch 14 is turned on, the holes 100 are discharged to the anode electrode 1 via the p-type region 12 from the n-type drift layer 11. Since the holes 100 are decreased, the resistance value of the n-type drift layer 11 sharply increases. Thus, the forward voltage drop VF sharply increases as illustrated in FIG. 2(b) due to the switch 14 being turned on.

Just after the switch 14 is turned on, Vr becomes 0.8 V or less. Therefore, the diode 10 according to the present embodiment operates such that the Vr always becomes 0.8 V or less during the on period of the switch 14 by inputting a high-frequency pulse to the switch 14, thereby being capable of reducing the forward voltage drop VF of the diode 10.

In second to fourth embodiments described later, the sharp increase of the forward voltage drop VF is prevented.

### (Effect of first embodiment)

The first embodiment described above has effects (A) and (B) described below.

(A) In the conduction state, the diode 10 operates such that the Vr always becomes 0.8 V or less during the on period of the switch 14 by inputting a high-frequency pulse to the switch 14. Accordingly, the forward voltage drop VF of the diode 10 can be reduced.

(B) The diode 10 uses only one switch 14. Therefore, the diode 10 can reduce the mounting area and cost more than the diode 10Z using two switches 14 and 14i described in NPLs 1 and 2.

### (Configuration of second embodiment)

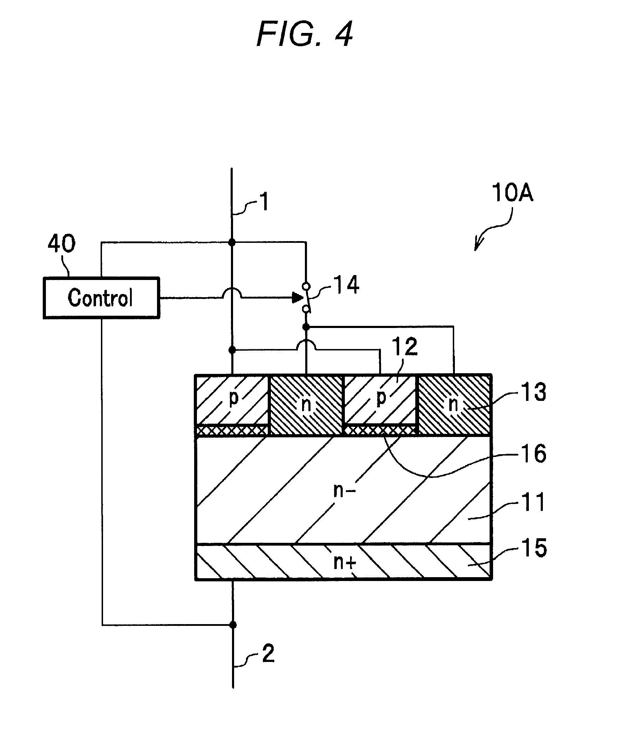

FIG. 4 is a diagram illustrating a cross-sectional configuration of a diode according to a second embodiment.

Different from the diode 10 (FIG. 1) according to the first embodiment, a diode 10A according to the second embodiment includes an n-type hole barrier layer 16 on an interface between a p-type region 12 and an n-type drift layer 11. An impurity concentration of the hole barrier layer 16 is higher than that of the n-type drift layer 11. The diode 10A according to the second embodiment is configured similar to the diode 10 (FIG. 1) according to the first embodiment except for the portion described above.

### (Operation of second embodiment)

An operation of the diode 10A will be described with reference to FIG. 4, and FIG. 2 according to need.

The hole barrier layer 16 prevents holes from being discharged to the anode electrode 1 via the p-type region 12 just after the switch 14 is turned on. Thus, the forward voltage drop VF of the diode 10A does not sharply increase as indicated by the solid line Vr in FIG. 2(b), but becomes close to an ideal waveform indicated by the dotted line Vi in FIG. 2(b).

With this configuration, the diode 10A according to the second embodiment can reduce the forward voltage drop VF and reduce the conduction loss.

When the impurity concentration of the hole barrier layer 16 is high, the diode 10A has problems of "deterioration in breakdown voltage" and "reduction in hole injection amount to the n-type drift layer 11 (semiconductor substrate) from the p-type region 12". On the other hand, when the impurity concentration is too low, the hole barrier layer 16 cannot exhibit a function of a hole barrier (= prevention of the discharge of hole). Specifically, the impurity concentration of the hole barrier layer 16 has an optimum range. The optimum range of a peak of the impurity concentration of the hole barrier layer 16 is 1 × 10¹⁶ cm⁻³ to 1 × 10¹⁸ cm⁻³ according to the experiment conducted by the inventors of the subject application.

A thickness of the hole barrier layer 16 also has an optimum range. When the thickness of the hole barrier layer 16 is too large, the diode 10A has problems of "deterioration in breakdown voltage" and "reduction in hole injection amount to the n-type drift layer 11 (semiconductor substrate) from the p-type region 12". On the other hand, when the thickness is too small, the hole barrier layer 16 cannot exhibit a function of a hole barrier (= prevention of the discharge of hole). The optimum range of the thickness of the hole barrier layer 16 is 0.2 µm to 2.0 µm according to the experiment conducted by the inventors of the subject application.

### (Effect of second embodiment)

The second embodiment described above has the effect (C) described below.

(C) The diode 10A can reduce the forward voltage drop VF and reduce the conduction loss.

### (Configuration of third embodiment)

In the diode 10 (FIG. 1) according to the first embodiment and the diode 10A (FIG. 4) according to the second embodiment, high voltage is applied to the switch 14 in a state in which reverse voltage is applied, that is, positive voltage is applied to the cathode electrode 2 and negative voltage is applied to the anode electrode 1. Therefore, a high breakdown voltage switch has to be used for the switch 14. A diode 10B according to the present embodiment is provided for solving this problem.

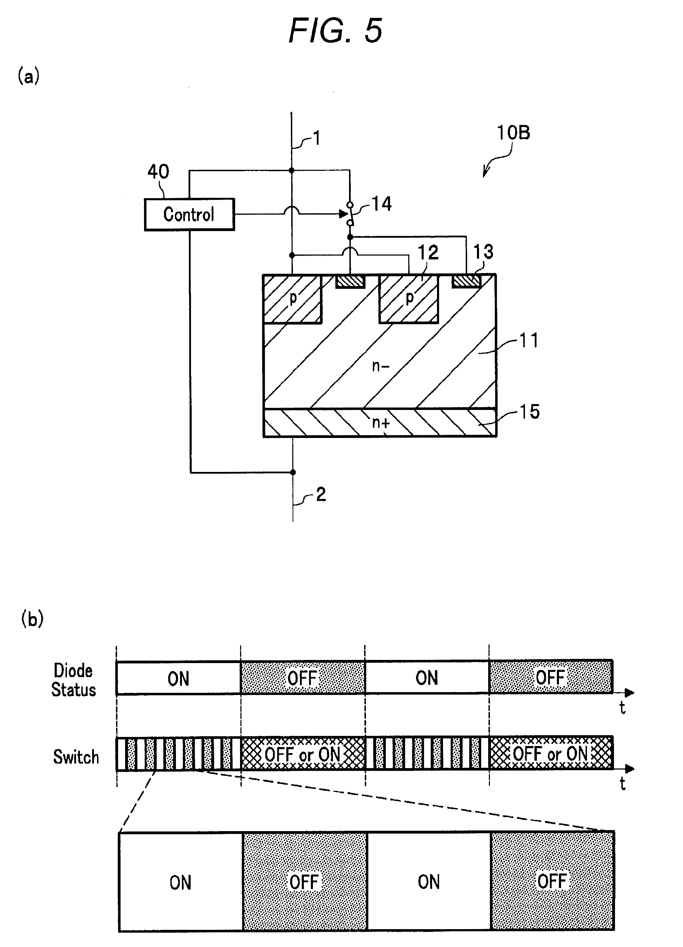

FIGS. 5(a) and 5(b) are diagrams illustrating a configuration and operation of the diode according to the third embodiment.

FIG. 5(a) is a sectional view illustrating the diode 10B.

An n-type region 13 and a p-type region 12 are formed on the surface (first surface) of the diode 10B according to the third embodiment as being separated by an n-type drift layer 11 and being close to each other.

Different from the diode 10 (FIG. 1) according to the first embodiment, the diode 10B according to the third embodiment is configured such that the thickness of the n-type region 13 is smaller than the thickness of the p-type region 12.

The diode 10B according to the third embodiment is configured similar to the diode 10 (FIG. 1) according to the first embodiment except for the portion described above.

In the non-conduction state, depletion layers of the diode 10B according to the third embodiment extending from the adjacent p-type regions 12 are brought into contact with each other (pinch-off), so that high voltage is not applied to the n-type region 13. With this configuration, any switch 14 can be used, regardless of the breakdown voltage. Therefore, a low breakdown voltage switch can also be used for the switch 14.

Since the breakdown voltage of the switch 14 becomes no problem, whether the switch 14 is turned on or off in the non-conduction state of the diode 10B does not matter. Specifically, whether the switch 14 is turned on or off does not matter just before the diode 10B is changed to the non-conduction state.

In addition, the diode 10B can reduce a conduction loss of the switch 14, since high voltage is not applied to the switch 14.

### (Operation of third embodiment)

In the non-conduction state, high voltage is applied to the switch 14 in the diode 10 (FIG. 1) according to the first embodiment. Therefore, the switch 14 has to be turned off. For this, holes are injected into the n-type drift layer 11 (semiconductor substrate) from the p-type region 12 just before the diode 10 (FIG. 1) is changed to the non-conduction state, whereby the recovery loss of the diode 10 (FIG. 1) might be increased.

FIG. 5(b) is a diagram illustrating the operation of a control unit 40 in the diode 10B.

A "Diode Status" at an upper chart indicates the conduction state and the non-conduction state of the diode 10B. In the "Diode Status", "ON" in a white part indicates the conduction state of the diode 10B, while "OFF" in a gray part indicates the non-conduction state of the diode 10B.

A "Switch" in a lower chart illustrates an on-state and an off-state of the switch 14. In the "Switch", "ON" in a white part indicates the on-state of the switch 14, "OFF" in a gray part indicates the off-state of the switch 14, and "OFF or ON" in an oblique check pattern indicates whether the switch 14 is turned on or off does not matter. The "Switch" also indicates a signal outputted to the switch 14 by the control unit 40. A horizontal axis in FIG. 5(b) indicates a common time.

The lowermost chart illustrates the "Switch" in the conduction state (ON) of the diode 10B with the time axis being enlarged.

Different from the diode 10 (FIG. 2(a)) according to the first embodiment, the diode 10B according to the third embodiment turns on the switch 14 just before the diode 10B is changed to the non-conduction state. The switch 14 makes the n-type region 13 short-circuited to the anode electrode 1. With this, the diode 10B suppresses the injection of holes into the n-type drift layer 11 (semiconductor substrate) from the p-type region 12, thereby being capable of reducing the recovery loss.

### (Effect of third embodiment)

The third embodiment described above has the effects of (D) to (F) described below.

(D) In the non-conduction state, the depletion layers of the diode 10B extending from the adjacent p-type regions 12 are in contact with each other (= pinch-off), so that high voltage is not applied to the n-type region 13. Thus, any switch 14 can be used, regardless of the breakdown voltage. Accordingly, a low breakdown voltage switch can be used for the switch 14.

(E) Since high voltage is not applied to the switch 14, the diode 10B can reduce the conduction loss of the switch 14.

(F) The diode 10B can suppress the injection of holes into the n-type drift layer 11 (semiconductor substrate) from the p-type region 12, thereby being capable of reducing the recovery loss.

### (Configuration of fourth embodiment)

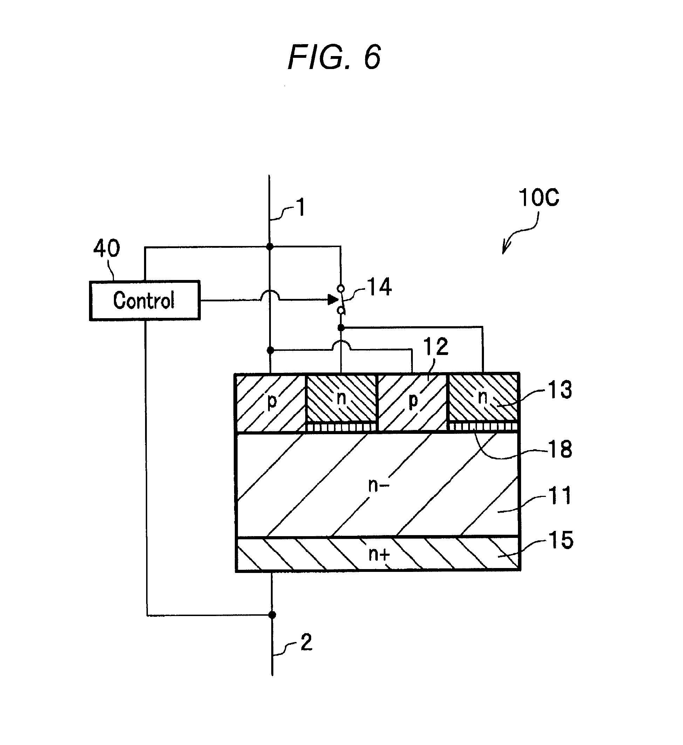

FIG. 6 is a diagram illustrating a cross-sectional configuration of a diode according to a fourth embodiment.

Different from the diode 10 (FIG. 1) according to the first embodiment, a diode 10C according to the fourth embodiment includes a p-type region 18 on an interface between an n-type region 13 and an n-type drift layer 11.

With this configuration, in the diode 10C according to the present embodiment, depletion layers of the p-type regions 18 are in contact with each other (pinch-off) in the non-conduction state, so that voltage is not applied to the n-type region 13. With this, a breakdown voltage of a switch 14 does not matter.

Compared to the diode 10 (FIG. 1) according to the first embodiment, a low breakdown voltage switch can be used for the switch 14, and the conduction loss of the switch 14 can be reduced in the diode 10C, since the breakdown voltage of the switch 14 does not matter.

The diode 10C according to the fourth embodiment turns on the switch 14 just before the diode 10C is changed to the non-conduction state. With this, the diode 10C suppresses the injection of holes into the n-type drift layer 11 (semiconductor substrate) from the p-type region 12, thereby being capable of reducing the recovery loss.

### (Effect of fourth embodiment)

The fourth embodiment described above has the effects (G) to (I) described below.

(G) In the diode 10C, depletion layers of the p-type regions 18 are in contact with each other (pinch-off) in the non-conduction state, so that voltage is not applied to the n-type region 13. With this, the breakdown voltage of the switch 14 does not matter.

(H) Compared to the diode 10 (FIG. 1) according to the first embodiment, a low breakdown voltage switch can be used for the switch 14, and the conduction loss of the switch 14 can be reduced in the diode 10C, since the breakdown voltage of the switch 14 does not matter.

(I) The diode 10C turns on the switch 14 just before the diode 10C is changed to the non-conduction state. With this, the diode 10C suppresses the injection of holes into the n-type drift layer 11 (semiconductor substrate) from the p-type region 12, thereby being capable of reducing the recovery loss.

### (Configuration of fifth embodiment)

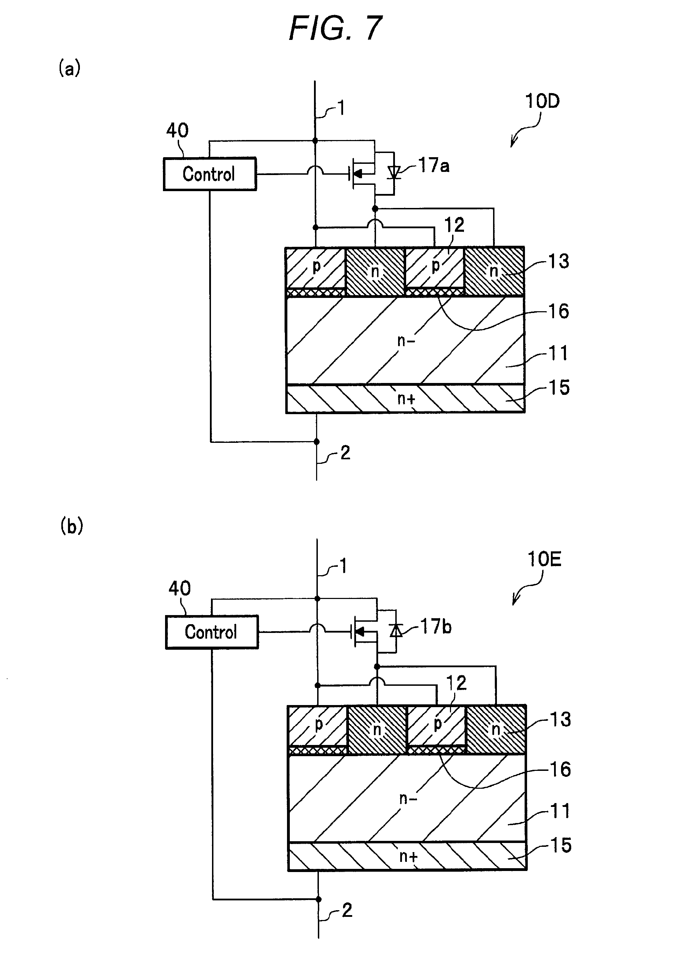

FIGS. 7(a) and 7(b) are diagrams illustrating cross-sectional configurations of diodes according to fifth and sixth embodiments.

FIG. 7(a) is a diagram illustrating a cross-sectional configuration of a diode 10D according to the fifth embodiment.

Different from the diode 10A (FIG. 4) according to the second embodiment, the diode 10D according to the fifth embodiment employs a MOSFET (Metal-Oxide-Semiconductor Field-Effect Transistor) 17a for the switch 14. A source of the MOSFET 17a is connected to an anode electrode 1. A drain of the MOSFET 17a is connected to an n-type region 13. The MOSFET 17a has a parasitic diode from the source to the drain. With this configuration, the diode 10D according to the fifth embodiment can also be used for the case where high voltage is applied to the anode electrode 1 and the n-type region 13, that is, the case where a high breakdown voltage is demanded.

The diode 10D according to the fifth embodiment turns on and off the MOSFET 17a with a high-frequency pulse in the conduction state, thereby being capable of reducing the conduction loss.

### (Effect of fifth embodiment)

The fifth embodiment described above has the effects (J) and (K) described below.

(J) The MOSFET 17a can also be used for the case where high voltage is applied to the anode electrode 1 and the n-type region 13, that is, the case where a high breakdown voltage is demanded.

(K) The diode 10D turns on and off the MOSFET 17a with a high-frequency pulse in the conduction state, thereby being capable of reducing the conduction loss.

### (Configuration of sixth embodiment)

FIG. 7(b) is a diagram illustrating a cross-sectional configuration of a diode 10E according to the sixth embodiment.

Different from the diode 10D (FIG. 7(a)) according to the fifth embodiment, a source and a drain of a MOSFET 17b are connected in the opposite way in the diode 10E according to the sixth embodiment. The drain of the MOSFET 17b is connected to the anode electrode 1. The drain of the MOSFET 17b is connected to an n-type region 13. The MOSFET 17a includes a parasitic diode from the source to the drain.

As described in the third embodiment, the breakdown voltage of the MOSFET 17b does not matter by optimizing the thickness of the p-type region 12 and the thickness of the n-type region 13. In this case, the drain of the MOSFET 17b can be connected to the anode electrode 1, and the source of the MOSFET 17b can be connected to the n-type region 13 as in the diode 10E according to the present embodiment.

The diode 10E according to the sixth embodiment turns on and off the MOSFET 17b with a high-frequency pulse in the conduction state, thereby being capable of reducing the conduction loss.

In addition, the diode 10E turns on the MOSFET 17b just before the diode 10E is changed to the non-conduction state, thereby being capable of suppressing the injection of holes into the n-type drift layer 11 (semiconductor substrate) from the anode electrode 1 to reduce the recovery loss.

### (Effect of sixth embodiment)

The sixth embodiment described above has the effects (L) and (M) described below.

(L) The diode 10E turns on and off the MOSFET 17b with a high-frequency pulse in the conduction state, thereby being capable of reducing the conduction loss.

(M) The diode 10E turns on the MOSFET 17b just before the diode 10E is changed to the non-conduction state, thereby being capable of suppressing the injection of holes into the n-type drift layer 11 (semiconductor substrate) from the anode electrode 1 to reduce the recovery loss.

### (Configuration of seventh embodiment)

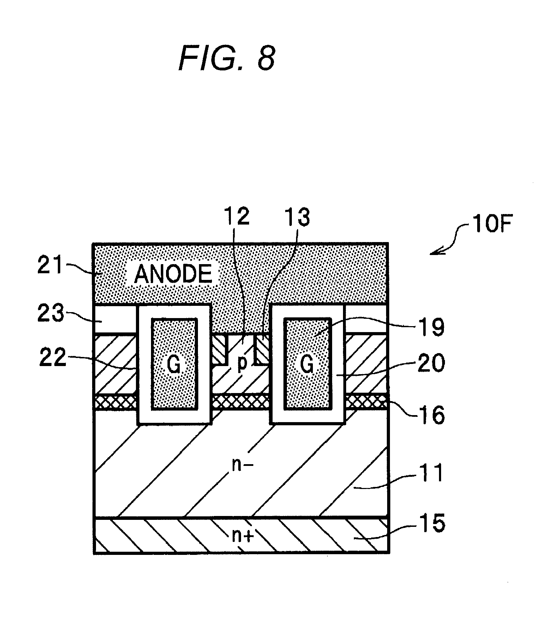

FIG. 8 is a sectional view of a diode according to the seventh embodiment.

A diode 10F according to the seventh embodiment includes a MOS gate 22 having a second gate electrode 19 and a second gate insulating film 20, an anode electrode 21, and an insulating layer 23, in addition to the components of the diode 10 (FIG. 1) according to the first embodiment.

The diode 10F includes, on the surface of the semiconductor substrate, a hole barrier layer 16, a p-type region 12 mounted at the outside of the hole barrier layer 16, the MOS gate 22 mounted in a trench, which penetrates the hole barrier layer 16 and the p-type region 12 to reach a semiconductor substrate, an n-type region 13 formed on a portion in contact with the surface of the p-type region 12 and the MOS gate 22, the anode electrode 21 that is in contact with the p-type region 12 and the n-type region 13, and the insulating layer 23 that electrically isolates the portion other than the portion adjacent to the p-type region 12 and the n-type region 13.

The second gate electrode 19 of the MOS gate 22 is isolated from the semiconductor substrate, the p-type region 12, and the n-type region 13 by the second gate insulating film 20.

The diode 10F also includes a control unit 40 that repeatedly outputs an on signal and an off signal to the second gate electrode 19 during the period when the forward voltage is applied.

With this, the configuration in which the MOSFET 17a according to the fifth embodiment is incorporated in the semiconductor substrate of the diode 10F can be realized. When the unillustrated control unit 40 applies voltage higher than the voltage of the anode electrode 21, the interface between the p-type region 12 and the second gate insulating film 20 is inversed into n-type, whereby the anode electrode 21 and the n-type drift layer 11 are short-circuited. When the unillustrated control unit 40 applies voltage equal to or lower than the voltage of the anode electrode 21 to the second gate electrode 19, the n-type inversion layer is eliminated, and the anode electrode 21 is connected to the n-type drift layer 11 via the p-type region 12.

The diode 10F according to the seventh embodiment turns on and off the MOSFET 17a with a high-frequency pulse in the conduction state, thereby being capable of reducing the conduction loss.

In addition, the diode 10F turns on the MOSFET 17a just before the diode 10F is changed to the non-conduction state, thereby being capable of suppressing the injection of holes into the n-type drift layer 11 (semiconductor substrate) from the anode electrode 21 to reduce the recovery loss.

In the diode 10F according to the seventh embodiment, the MOSFET 17a is incorporated into the substrate of the diode 10F. With this configuration, the diode 10F does not need an external switch 14, whereby the diode 10F can be made compact.

### (Effect of seventh embodiment)

The seventh embodiment described above has the effect (N) in addition to the effects of the fifth embodiment.

(N) In the diode 10F, the MOSFET 17a is incorporated into the substrate of the diode 10F. With this configuration, the diode 10F does not need an external switch 14, whereby the diode 10F can be made compact.

### (Configuration of eighth embodiment)

As described in the first to seventh embodiments, the n-type region 13 and the p-type region 12 are arranged to be adjacent to each other at the side of the anode electrode 1 of the diodes 10 to 10F, wherein the p-type region 12 and the anode electrode 1 are short-circuited, and the n-type region 13 is connected to the anode electrode 1 via the switch 14. The diodes 10 to 10F turn on and off the switch 14 with a high-frequency pulse in the conduction state, thereby reducing the forward voltage drop VF. The diodes 10 to 10F turn on the switch 14 just before the recovery to reduce the recovery loss.

The eighth embodiment applies the present invention to a switching device.

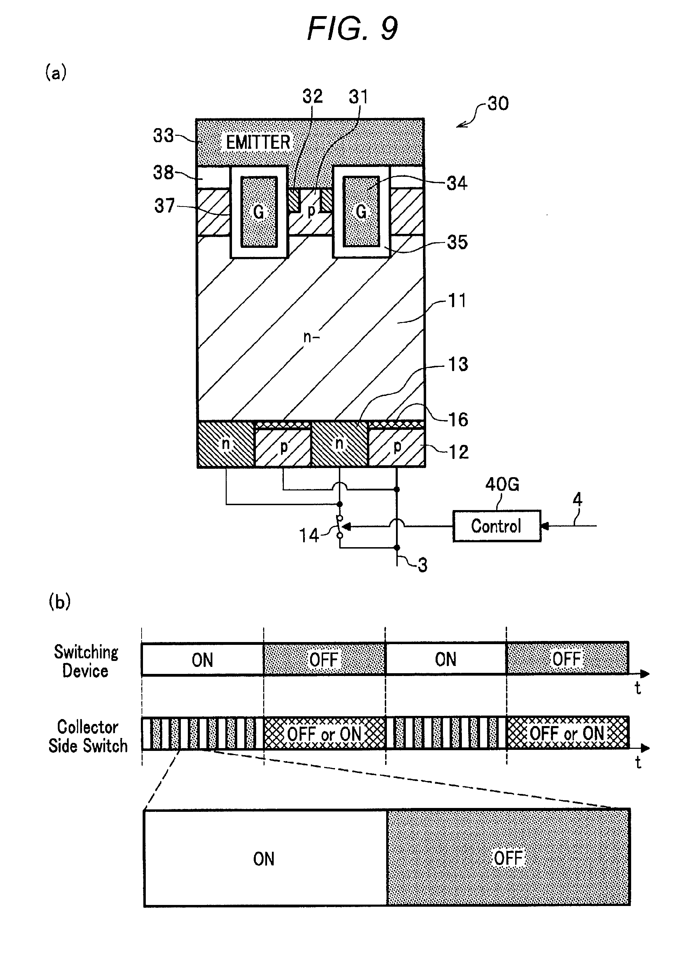

FIGS. 9(a) and 9(b) are diagrams illustrating a configuration and an operation of a switching device according to the eighth embodiment.

FIG. 9(a) is a diagram illustrating a cross-sectional configuration of the switching device 30 according to the eighth embodiment.

For example, the switching device 30 (semiconductor device) that is an IGBT includes, on a surface (first surface) of the semiconductor substrate, a p-type channel region 31 having a first conductive type, an n-type source region 32 having a second conductive type, an emitter electrode 33, a MOS gate 37 having a gate electrode 34 and a gate insulating film 35, and an insulating layer 38. The switching device 30 includes, on a back surface (second surface) of the semiconductor substrate, a p-type region 12 having a first conductive type, an n-type region 13 having a second conductive type, a hole barrier layer 16 having a first conductive type, a switch 14, and a control unit 40G. An input signal 4 to the gate electrode 34 is the same as an input signal to the control unit 40G. When voltage is applied between the emitter electrode 33 and the collector electrode 3, the switching device 30 is changed into a conduction state or a non-conduction state according to the input signal to the gate electrode 34.

The switching device 30 includes, on the surface (first surface) of the semiconductor substrate, the p-type channel region 31, the MOS gate 37 formed on a trench, which penetrates the p-type channel region 31 to reach the semiconductor substrate, the n-type source region 32 formed on a portion in contact with the surface of the p-type channel region 31 and the MOS gate 37, the emitter electrode 33 that is in contact with the p-type channel region 31 and the n-type source region 32, and the insulating layer 38 that electrically isolates the portion other than the portion adjacent to the p-type channel region 31 and the n-type source region 32.

The control unit 40G controls to repeatedly turn on and off the switch 14 during the period when current flows from the emitter electrode 33 to the collector electrode 3. The input signal 4 is inputted to the control unit 40G, and also inputted to the gate electrode 34.

The gate electrode 34 of the MOS gate 37 is isolated from the semiconductor substrate, the p-type region 12, and the n-type region 13 by the gate insulating film 35.

The back surface (second surface) of the switching device 30 is configured similar to the surface of the diode 10A (FIG. 4) according to the second embodiment. Specifically, the configuration in which the p-type region 12 and the n-type region 13 are adjacent to each other is formed on the back surface of the semiconductor substrate. The n-type hole barrier layer 16 is formed on the interface between the p-type region 12 and the n-type drift layer 11. The impurity concentration of the hole barrier layer 16 is higher than that of the n-type drift layer 11.

The p-type region 12 is connected to the collector electrode 3. The n-type region 13 is connected to the collector electrode 3 via the switch 14. An output terminal of the control unit 40G is connected to a control terminal of the switch 14.

### (Operation of eighth embodiment)

When positive voltage is applied to the gate electrode 34, an n-type inversion layer is formed on the interface between the p-type channel region 31 and the gate insulating film 35, whereby the switching device 30 becomes the conduction state. The input signal 4 that is inputted to the gate electrode 34 is inputted to the control unit 40G, and the control unit 40G detects the conduction state of the switching device 30.

When the input signal 4 with the positive voltage is inputted, the control unit 40G turns on and off the switch 14 at the side of the collector electrode 3 with a high-frequency pulse. With this operation, the on voltage of the switching device 30 can be reduced due to the mechanism similar to the mechanism of the diodes 10 to 10F according to the first to seventh embodiments.

As described in the third and fourth embodiments, a countermeasure of pinching off the n-type region 13 by the p-type region 12 has to be taken for preventing the high voltage from being applied to the switch 14 at the side of the anode electrode 1 in the non-conduction state of the diodes 10B and 10C, that is, in the state in which reverse voltage is applied to the diodes 10B and 10C.

On the other hand, high voltage is not applied to the switch 14 at the side of the collector electrode 3 of the switching device 30 even when the switch 14 is turned off. Thus, the breakdown voltage of the switch 14 does not matter. In other words, the switch 14 may be turned on or off in the non-conduction state of the switching device 30. With this, there is no limitation about the on and off of the switch 14 just before the switching device 30 is changed to the non-conduction state. When the switch 14 at the side of the collector electrode 3 is turned on just before the switching device 30 is turned off (changed to the non-conduction state), the injection of holes into the n-type drift layer 11 (semiconductor substrate) from the p-type region 12 on the back surface is suppressed, whereby the turn-off loss can be reduced.

FIG. 9(b) is a diagram illustrating an on/off timing of the switch 14 at the side of the collector electrode 3 in the eighth embodiment.

A "Switching Device" at an upper chart illustrates the conduction state and the non-conduction state of the switching device 30. In the "Switching Device", "ON" in a white part indicates the conduction state of the switching device 30, while "OFF" in a gray part indicates the non-conduction state of the switching device 30.

A "Collector Side Switch" at a lower chart illustrates the on-state and off-state of the switch 14 at the side of the collector electrode 3. In the "Collector Side Switch", "ON" in a white part indicates the on-state of the switch 14 at the side of the collector electrode 3, "OFF" in a gray part indicates the off-state of the switch 14 at the side of the collector electrode 3, and "OFF or ON" in an oblique check pattern indicates whether the switch 14 at the side of the collector electrode 3 is turned on or off does not matter. The "Collector Side Switch" also indicates a signal outputted to the switch 14 at the side of the collector electrode 3 by the control unit 40G. The lowermost chart illustrates the "Collector Side Switch" in the conduction state of the switching device 30 with the time axis being enlarged.

In the conduction state of the switching device 30, the control unit 40 turns on and off the switch 14 at the side of the collector electrode 3 with a high-frequency pulse.

In the on-state of the switch 14 at the side of the collector electrode 3, holes are not injected into the n-type drift layer 11 (semiconductor substrate) or hole injection is suppressed.

In the off-state of the switch 14 at the side of the collector electrode 3, holes are injected into the n-type drift layer 11 (semiconductor substrate). In the non-conduction state of the switching device 30, whether the switch 14 at the side of the collector electrode 3 is turned on or off does not matter.

The switching device 30 turns on the switch 14 at the side of the collector electrode 3 just before it is changed to the non-conduction state. With this, the injection of holes into the n-type drift layer 11 (semiconductor substrate) is suppressed, whereby the turn-off loss can be reduced.

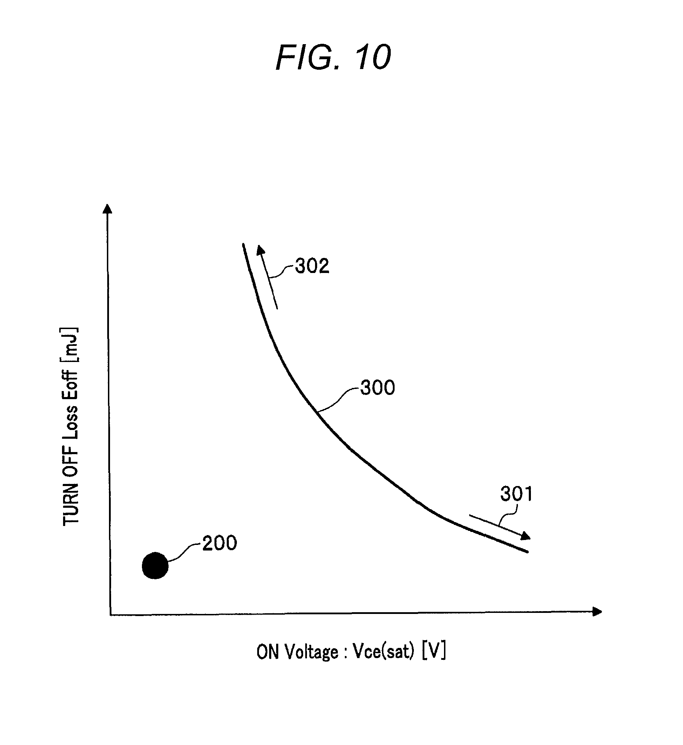

FIG. 10 is a diagram illustrating a relationship between the on voltage and the turn-off loss of the switching device. A horizontal axis in FIG. 10 indicates the on voltage Vce (sat) of the switching device 30. This on voltage Vce is saturation voltage between the collector and the emitter. A vertical axis in FIG. 10 indicates the turn-off loss Eoff [mJ] of the switching device 30.

A curve 300 indicates the relationship between the on voltage and the turn-off loss when holes are injected to the P-layer from the IGBT back surface upon manufacturing the switching device 30 that is the IGBT, for example. A dot 200 indicates the relationship between the on voltage and the turn-off loss of the switching device 30 (FIG. 9) according to the eighth embodiment.

As indicated by an arrow 301, when the hole injection is accelerated from the back surface of the IGBT upon manufacturing the IGBT (for example, by increasing the impurity concentration of the p-type emitter), the on voltage Vce decreases, but the turn-off loss Eoff increases.

When the hole injection from the back surface of the IGBT is suppressed upon manufacturing the IGBT (for example, by reducing the impurity concentration of the p-type emitter), the on voltage Vce increases, but the turn-off loss Eoff decreases, as indicated by an arrow 302. Specifically, the on voltage Vce and the turn-off voltage Eoff of the IGBT have a trade-off relation with the impurity concentration of the p-type emitter being used as a parameter.

In the conduction state, the switching device 30 (FIG. 9) according to the eighth embodiment repeatedly turns on and off the switch 14 with a high-frequency pulse. The switching device 30 injects holes into the n-type drift layer 11 (semiconductor substrate) by the high-frequency pulse. Thus, the on voltage Vce can be made smaller than the diffusion voltage (about 0.8 V) that is a limit of the IGBT.

In addition, the switching device 30 turns on the switch 14 at the side of the collector electrode 3 just before it is turned off (changed to the non-conduction state), thereby being capable of suppressing the injection of holes into the n-type drift layer 11 (semiconductor substrate). Accordingly, the switching device 30 can reduce the turn-off loss Eoff.

### (Effect of eighth embodiment)

The eighth embodiment described above has the effects (O) and (P) described below.

(O) In the conduction state, the switching device 30 injects holes into the n-type drift layer 11 (semiconductor substrate) by the high-frequency pulse. Thus, the on voltage Vce can be made smaller than the diffusion voltage (about 0.8 V) that is a limit of the IGBT.

(P) In addition, the switching device 30 turns on the switch 14 at the side of the collector electrode 3 just before it is turned off (changed to the non-conduction state), thereby being capable of suppressing the injection of holes into the n-type drift layer 11 (semiconductor substrate). Accordingly, the switching device 30 can reduce the turn-off loss Eoff.

### (Configuration of ninth embodiment)

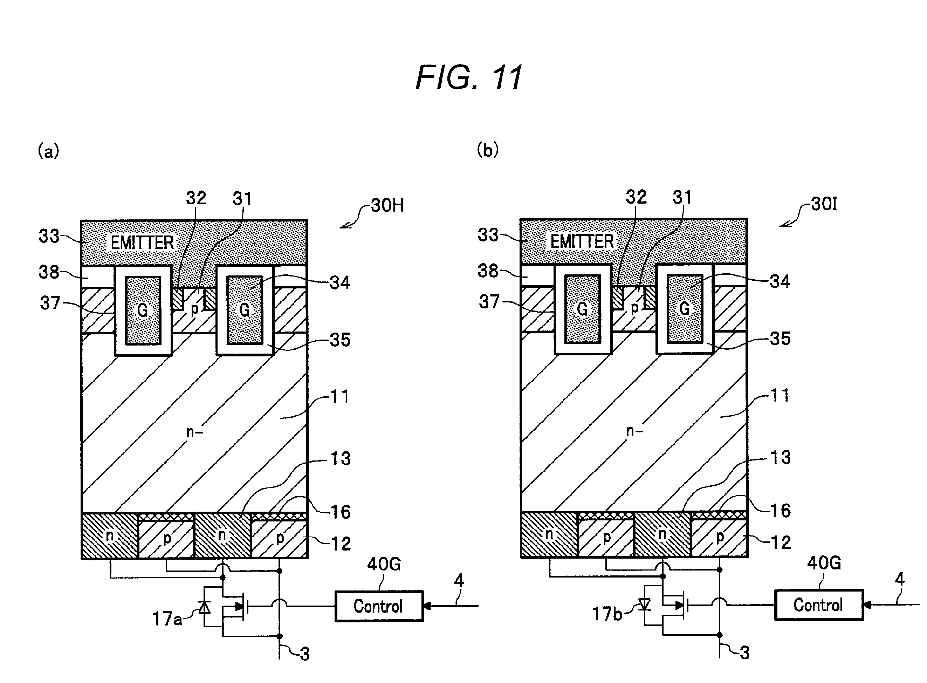

FIGS. 11(a) and 11(b) are diagrams illustrating cross-sectional configurations of switching devices according to ninth and tenth embodiments.

FIG. 11(a) is a diagram illustrating a cross-sectional configuration of a switching device 30H according to the ninth embodiment.

The switching device 30H according to the ninth embodiment includes a MOSFET 17a as the switch 14 at the side of the collector electrode 3 in the switching device 30 (FIG. 9) according to the eighth embodiment. A source of the MOSFET 17a is connected to the collector electrode 3. A drain of the MOSFET 17a is connected to the n-type region 13.

In the conduction state of the switching device 30H, the control unit 40G turns on and off the MOSFET 17a with a high-frequency pulse. Thus, the on voltage of the switching device 30H can be reduced.

In addition, the MOSFET 17a is turned on just before the switching device 30H is turned off, whereby the turn-off loss of the switching device 30H can be reduced.

### (Effect of ninth embodiment)

The ninth embodiment described above has the effects (Q) and (R) described below.

(Q) In the conduction state of the switching device 30H, the control unit 40G turns on and off the MOSFET 17a with a high-frequency pulse. Thus, the on voltage of the switching device 30H can be reduced.

(R) In addition, the MOSFET 17a is turned on just before the switching device 30H is turned off, whereby the turn-off loss of the switching device 30H can be reduced.

### (Configuration of tenth embodiment)

FIG. 11(b) is a diagram illustrating a cross-sectional configuration of a switching device 30I according to the tenth embodiment.

Different from the switching device 30H (FIG. 11(a)) according to the ninth embodiment, a source and a drain of a MOSFET 17b are inversely connected in the switching device 30I according to the tenth embodiment.

As described in the ninth embodiment, the breakdown voltage of the switch at the side of the collector electrode 3 of the switching device 30I does not matter. Therefore, the connecting direction of the MOSFET 17b does not matter.

In the conduction state, the switching device 30I according to the tenth embodiment turns on and off the MOSFET 17b with a high-frequency pulse. Thus, the on voltage of the switching device 30I can be reduced.

The MOSFET 17b is turned on just before the switching device 30I is turned off, whereby the turn-off loss of the switching device 30I can be reduced.

### (Effect of tenth embodiment)

The tenth embodiment described above has the effects (S) and (T) described below.

(S) In the conduction state, the switching device 30I turns on and off the MOSFET 17b with a high-frequency pulse. Thus, the on voltage of the switching device 30I can be reduced.

(T) The MOSFET 17b is turned on just before the switching device 30I is turned off, whereby the turn-off loss of the switching device 30I can be reduced.

### (Configuration of eleventh embodiment)

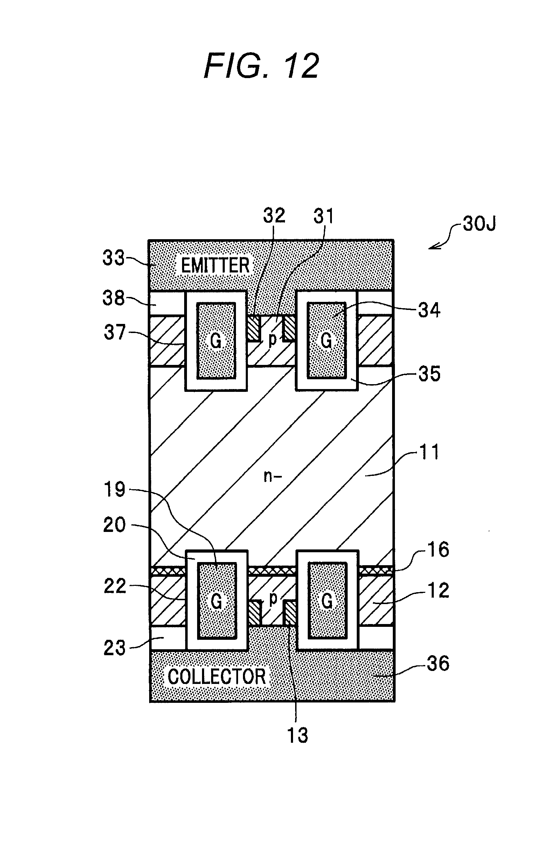

FIG. 12 is a sectional view illustrating a switching device according to the eleventh embodiment.

Different from the switching device 30H (FIG. 11(a)) according to the ninth embodiment, a switch (MOSFET) at the side of a collector electrode 36 is incorporated into a semiconductor substrate of a switching device 30J according to the present embodiment.

The switching device 30J includes, on a surface (first surface) of the semiconductor substrate, a p-type channel region 31, a gate electrode 34 formed on a trench, which penetrates through the p-type channel region 31 to reach the semiconductor substrate, and isolated from the semiconductor substrate and the p-type channel region 31 by a gate insulating film 35, an n-type source region 32 formed on a portion in contact with the surface of the p-type channel region 31 and the gate insulating film 35 and serving as an emitter region with a first conductive type, and an emitter electrode 33 that is in contact with the p-type channel region 31 and the n-type source region 32.

The switching device 30J includes, on a back surface (second surface) of the semiconductor substrate, a p-type region 12 having a second conductive type and serving as a second channel region, a second gate electrode 19 formed on a second trench, which penetrates through the p-type region 12 to reach the semiconductor substrate, and isolated from the semiconductor substrate and the p-type region 12 by a second gate insulating film 20, an n-type region 13 that is formed on a part of the p-type region 12 to be in contact with the second gate insulating film 20 and serves as a collector region with a first conductive type, and a collector electrode 36 that is in contact with the p-type region 12 and the n-type region 13.

The switching device 30J includes an n-type hole barrier layer 16 on the interface between the p-type region 12 and the semiconductor substrate. The impurity concentration of the hole barrier layer 16 is higher than the impurity concentration of the n-type drift layer 11 of the semiconductor substrate.

The switching device 30J also includes a control unit 40G (not illustrated) that repeatedly outputs an on signal and an off signal to the second gate electrode 19 during the period when current flows from the emitter electrode 33 to the collector electrode 36.

The gate electrode 34 on the surface of the semiconductor substrate (at the side of the emitter) has a function of turning on and off the collector current. The second gate electrode 19 on the back surface of the semiconductor substrate (at the side of the collector electrode 3) has a function of controlling the hole injection amount into the n-type drift layer 11 (semiconductor substrate).

In the switching device 30J according to the eleventh embodiment, the switch (MOSFET) at the side of the collector electrode 36 is incorporated into the semiconductor substrate. With this configuration, the external switch 14 is unnecessary, whereby the semiconductor device and the power conversion device (inverter) using the semiconductor device can be made compact.

In the conduction state of the switching device 30J, the control unit 40G (not illustrated) outputs a high-frequency pulse to the second gate electrode 19 to turn on and off the switch (MOSFET) at the side of the collector electrode 36. Thus, the switching device 30J can reduce the on voltage.

The unillustrated control unit 40G applies voltage to the second gate electrode 19 to turn on the switch (MOSFET) at the side of the collector electrode 36, just before the switching device 30J is changed to the non-conduction state. With this, the switching device 30J can reduce the turn-off loss.

### (Effect of eleventh embodiment)

The eleventh embodiment described above has the effects (U) to (W) described below.

(U) The switch (MOSFET) at the side of the collector electrode 36 is incorporated into the semiconductor substrate. With this structure, the external switch is unnecessary, whereby the semiconductor device and the power conversion device (inverter) using the semiconductor device can be made compact.

(V) In the conduction state of the switching device 30J, the control unit 40G (not illustrated) outputs a high-frequency pulse to the second gate electrode 19 to turn on and off the switch (MOSFET) at the side of the collector electrode 36. Thus, the switching device 30J can reduce the on voltage.

(W) The unillustrated control unit 40G applies voltage to the second gate electrode 19 to turn on the switch (MOSFET) at the side of the collector electrode 36, just before the switching device 30J is changed to the non-conduction state. With this, the switching device 30J can reduce the turn-off loss.

### (Modification)

The present invention is not limited to the above embodiments, and various modifications are possible without departing from the scope of the present invention. The modifications include (a) to (h) described below, for example.

(a) The inverter 500 that is a power conversion device illustrated in FIG. 13 may use the switching devices 30 to 30J according to the eighth to eleventh embodiments as the IGBT 700. With this configuration, a loss of the IGBT 700 in the inverter 500 can be reduced, whereby the loss of the inverter 500 can be reduced, and the inverter 500 can be made compact.

(b) The inverter 500 that is a power conversion device illustrated in FIG. 13 may use the diodes 10 to 10F according to the first to seventh embodiments as the fly wheel diode 600. With this configuration, a loss of the fly wheel diode 600 in the inverter 500 can be reduced, whereby the loss of the inverter 500 can be reduced, and the inverter 500 can be made compact.

(c) The configuration of the inverter 500 illustrated in FIG. 13 is only one example. The power conversion device (inverter) may be configured to include a switching leg in which an upper arm having a switching device and a diode that are connected antiparallel to each other and a lower arm having a switching device and a diode that are connected antiparallel to each other, wherein the switching legs in the number equal to a phase number of AC output are coupled.

(d) Not only the power conversion device (inverter) that converts DC into AC, but also a converter (power conversion device) that converts AC into DC may use the switching devices 30 to 30J according to the eighth to eleventh embodiments.

(e) The converter (power conversion device) that converts AC into DC may use the diodes 10 to 10F according to the first to seventh embodiments.

(f) The switch 14 according to the first to seventh embodiments is an n-type channel MOSFET. However, it is not limited thereto. The switch 14 may be a p-type channel MOSFET.

(g) In the first to eleventh embodiments, the first conductive type is defined as an n-type, and the second conductive type is defined as a p-type. However, they are not limited thereto. The first conductive type may be defined as a p-type, and the second conductive type may be defined as an n-type in the semiconductor device.

(h) The diode 10B (FIG. 5) according to the third embodiment is configured such that the thickness of the n-type region 13 is smaller than the thickness of the p-type region 12. However, it is not limited thereto. In addition to the structure in the third embodiment, the width of the n-type region 13 may be smaller than the width of the p-type region 12. With this configuration, the depletion layers extending from the adjacent p-type regions 12 are easy to be in contact with each other in the non-conduction state, whereby high voltage is not applied to the n-type region 13. Accordingly, a low breakdown voltage switch can be used as the switch 14.

### Reference Signs List

- 1: anode electrode
- 2: cathode electrode
- 3: collector electrode
- 10 to 10F: diode (semiconductor device)
- 11: n-type drift layer (semiconductor substrate)
- 12: p-type region (second conductive type anode region, second conductive type channel region, second conductive type collector region)
- 13: n-type region (first conductive type anode region, first conductive type collector region)
- 14, 14i: switch
- 15: high-concentration n-type region (first conductive type cathode region)
- 16: hole barrier layer (first conductive type hole barrier layer)
- 17: MOSFET
- 18: p-type region
- 19: second gate electrode
- 20: second gate insulating film
- 21: anode electrode
- 30 to 30J: switching device (semiconductor device)
- 31: p-type channel region (second conductive type channel region)
- 32: n-type source region (first conductive type emitter region)
- 33: emitter electrode
- 34: gate electrode
- 35: gate insulating film
- 36: collector electrode
- 100: hole
- 500: inverter (power conversion device)
- 600: fly wheel diode
- 700: IGBT
- 800: gate circuit
- 900: positive power source terminal
- 901: negative power source terminal
- 910u: U phase
- 910v: V phase
- 910w: W phase
- 950: motor
- 960: power source

## Claims

1. A semiconductor device comprising:
a semiconductor substrate of a first conductive type;
an anode region formed on a first surface of the semiconductor substrate;
a cathode region of a first conductive type formed on a second surface of the semiconductor substrate; and
an anode electrode, wherein
the first surface includes a structure in which a first conductive type anode region and a second conductive type anode region are adjacent to each other,
the second conductive type anode region is connected to the anode electrode, and
the first conductive type anode region is connected to the anode electrode via a switch.

2. The semiconductor device according to claim 1, further comprising:
a first conductive type hole barrier layer formed on an interface between the second conductive type anode region and the semiconductor substrate,
wherein an impurity concentration of the first conductive type hole barrier layer is higher than an impurity concentration of the semiconductor substrate.

3. A semiconductor device comprising:
a semiconductor substrate of a first conductive type;
an anode region formed on a first surface of the semiconductor substrate;
a cathode region of a first conductive type formed on a second surface of the semiconductor substrate; and
an anode electrode, wherein
the first surface includes a structure in which a first conductive type anode region and a second conductive type anode region are separated by a first conductive member of the semiconductor substrate and are formed close to each other,
the first conductive type anode region is thinner than the second conductive type anode region, and is connected to the anode electrode via a switch, and
the second conductive type anode region is connected to the anode electrode.

4. The semiconductor device according to claim 1, further comprising:
a second conductive type layer on an interface between the first conductive type anode region and the semiconductor substrate.

5. The semiconductor device according to claim 1, further comprising:
a control unit that controls to repeatedly turn on and off the switch during a period when forward voltage is applied to the semiconductor device.

6. The semiconductor device according to claim 5, wherein the control unit controls to turn on the switch during a period when reverse voltage is applied to the semiconductor device.

7. The semiconductor device according to claim 1, wherein the switch is a MOSFET.

8. A semiconductor device comprising a semiconductor substrate of a first conductive type, wherein
a first surface of the semiconductor substrate includes:
a channel region of a second conductive type;
a gate electrode that is formed on a trench, which penetrates the channel region to reach the semiconductor substrate, and that is isolated from the semiconductor substrate and the channel region by a gate insulating film;
an anode region of a first conductive type formed at a portion in contact with a surface of the channel region and the gate insulating film; and
an anode electrode that is in contact with the channel region and the anode region.

9. The semiconductor device according to claim 8, further comprising:
a control unit that repeatedly outputs an on signal and an off signal to the gate electrode during a period when forward voltage is applied to the semiconductor device.

10. The semiconductor device according to claim 8, further comprising:
a control unit that outputs an on signal to the gate electrode during a period when reverse voltage is applied to the semiconductor device.

11. A semiconductor device comprising a semiconductor substrate of a first conductive type, wherein
a first surface of the semiconductor substrate includes:
a channel region of a second conductive type;
a gate electrode that is formed on a trench, which penetrates the channel region to reach the semiconductor substrate, and that is isolated from the semiconductor substrate and the channel region by a gate insulating film;
an emitter region of a first conductive type formed at a portion in contact with the surface of the channel region and the gate insulating film; and
an emitter electrode that is in contact with the channel region and the emitter region,
a second surface of the semiconductor substrate includes:
a structure in which a first conductive type collector region and a second conductive type collector region are adjacent to each other,
the second conductive type collector region is connected to the collector electrode, and
the first conductive type collector region is connected to the collector electrode via a switch.

12. The semiconductor device according to claim 11, further comprising:
a first conductive type hole barrier layer formed on an interface between the second conductive type collector region and the semiconductor substrate,
wherein an impurity concentration of the first conductive type hole barrier layer is higher than an impurity concentration of the semiconductor substrate.

13. The semiconductor device according to claim 11, further comprising:
a control unit that controls to repeatedly turn on and off the switch during a period when current flows from the emitter electrode toward the collector electrode in the semiconductor device.

14. The semiconductor device according to claim 13,
wherein the control unit turns on the switch during a period when current does not flow from the emitter electrode toward the collector electrode in the semiconductor device.

15. The semiconductor device according to claim 11, wherein the switch is a MOSFET.

16. A semiconductor device comprising a semiconductor substrate of a first conductive type, wherein
a first surface of the semiconductor substrate includes:
a channel region of a second conductive type;
a gate electrode that is formed on a trench, which penetrates the channel region to reach the semiconductor substrate, and that is isolated from the semiconductor substrate and the channel region by a gate insulating film;
an emitter region of a first conductive type formed at a portion in contact with the surface of the channel region and the gate insulating film; and
an emitter electrode that is in contact with the channel region and the emitter region,
a second surface of the semiconductor substrate includes:
a second channel region of a second conductive type;
a second gate electrode that is formed on a second trench, which penetrates the second channel region to reach the semiconductor substrate, and that is isolated from the semiconductor substrate and the second channel region by a second gate insulating film;
a collector region of a first conductive type formed to be in contact with the second gate insulating film on a part of the surface of the second channel region; and
a collector electrode that is in contact with the second channel region and the collector region.

17. The semiconductor device according to claim 16, further comprising:
a first conductive type hole barrier layer formed on an interface between the second channel region and the semiconductor substrate,
wherein an impurity concentration of the first conductive type hole barrier layer is higher than an impurity concentration of the semiconductor substrate.

18. The semiconductor device according to claim 16, further comprising:
a control unit that controls to repeatedly output an on signal and an off signal to the second gate electrode during a period when current flows from the emitter electrode toward the collector electrode in the semiconductor device.

19. The semiconductor device according to claim 18,
wherein the control unit outputs the on signal to the second gate electrode during a period when current does not flow from the emitter electrode toward the collector electrode in the semiconductor device.

20. A power conversion device that converts DC voltage applied to a pair of DC terminals into AC, and outputs the resultant AC to AC terminals in a number equal to a phase number of the AC, the power conversion device comprising:
power conversion units in a number equal to the phase number of the AC, the power conversion units being connected between the pair of the DC terminals, wherein
each of the power conversion units includes two parallel circuits, each including a switching device and a diode of a reverse polarity, the two parallel circuits being connected in series, and each of the power conversion units outputs AC power to the AC terminal from a connection node between the parallel circuits, and
the diode is the semiconductor device according to any one of claims 1 to 10.

21. A power conversion device that converts DC voltage applied to a pair of DC terminals into AC, and outputs the resultant AC to AC terminals in a number equal to a phase number of the AC, the power conversion device comprising:
power conversion units in a number equal to the phase number of the AC, the power conversion units being connected between the pair of the DC terminals, wherein
each of the power conversion units includes two parallel circuits, each including a switching device and a diode of a reverse polarity, the two parallel circuits being connected in series, and each of the power conversion units outputs AC power to the AC terminal from a connection node between the parallel circuits, and
the switching device is the semiconductor device according to any one of claims 11 to 19.
